# EUROPEAN PATENT APPLICATION

(11) **EP 3 771 091 A1**
(43) Date of publication of application: **27.01.2021**
(21) Application number: 19771849.7
(22) Date of filing: 13.03.2019
(51) Int. Cl.: H02S 40/22, C03C 27/06, E06B 5/00

(54) **GLASS BUILDING MATERIAL**

(30) Priority: 20.03.2018 JP 2018052362
(71) Applicant: Kaneka Corporation, Osaka-shi, Osaka 530-8288 (JP)
(72) Inventor: UMEDA, Kazuhiko, Tokyo 163-0606 (JP); KOBAYASHI, Nobusato, Tokyo 163-0606 (JP); KINOSHITA, Seiichi, Tokyo 163-0606 (JP); KADOTA, Naoki, Toyooka-shi, Hyogo 668-0831 (JP); MATSUO, Hideki, Toyooka-shi, Hyogo 668-0831 (JP); MAKINO, Tsukasa, Toyooka-shi, Hyogo 668-0831 (JP); OHTA, Nobuhisa, Osaka-shi, Osaka 530-8288 (JP); NAKAJIMA, Akihiko, Osaka-shi, Osaka 530-8288 (JP)
(74) Representative: V.O.
(86) International application number: PCT/JP2019/010288
(87) International publication number: WO 2019/181688

(57) **Abstract**

A glass building material according to the present disclosure includes: a photovoltaic array including a first photovoltaic string of a bifacial light-receiving type, which has a shape extending in a first direction, and a second photovoltaic string of a bifacial light-receiving type, which is arranged next to the first photovoltaic string in a second direction crossing the first direction, and which has a shape extending in the first direction; a first glass substrate covering a first principal surface side of the photovoltaic array; a reflective film, which is arranged at least partially on a second principal surface side of the photovoltaic array, which has a transmittance higher than a reflectance thereof in a visible light region, and which has a reflectance higher than a transmittance thereof in a near-infrared region; and an air layer interposed between the photovoltaic array and the reflective film.

## Description

### TECHNICAL FIELD

The present invention relates to a glass building material.

### BACKGROUND ART

In Non Patent Literature 1 provided below, there is disclosed a bifacial light-receiving-type photovoltaic solar module installed vertically to the ground.

### CITATION LIST

### Non Patent Literature

[NPL 1] Toshio Joge et al., "Basic Application Technologies of Bifacial Photovoltaic Solar Modules," IEEJ Transactions B, Vol. 123, No. 8, 2003, p. 947-955

### SUMMARY OF INVENTION

### Technical Problem

When the bifacial light-receiving-type photovoltaic solar module in the related art is installed in, for example, a window of a building, a power generation amount on a light-receiving surface on an indoor side has been small. Specifically, the light-receiving surface on the indoor side cannot efficiently receive solar light from outside a room to result in a small power generation amount.

Meanwhile, a lighting-type photovoltaic solar module in the related art uses, for the purpose of increasing a power generation amount, a glass having a high solar radiation transmittance, and as a result, has a problem of an increase in cooling load of a building.

The present disclosure has been made in view of the above-mentioned problems, and therefore has an object to increase a power generation amount on a light-receiving surface on an indoor side when a glass building material including photovoltaic strings is installed in, for example, a window of a building.

Another object of the present disclosure is to reduce a cooling load to achieve energy saving of the building, and to ensure a view without any feeling of oppression and improve lighting performance.

### Solution to Problem

(1) A glass building material according to the present disclosure includes: a photovoltaic array including: a first photovoltaic string of a bifacial light-receiving type, which has a shape extending in a first direction; and a second photovoltaic string of a bifacial light-receiving type, which is arranged next to the first photovoltaic string in a second direction crossing the first direction, and has a shape extending in the first direction; a first glass substrate covering a first principal surface side of the photovoltaic array; a reflective film, which is arranged at least partially on a second principal surface side of the photovoltaic array, the reflective film having a transmittance higher than a reflectance thereof in a visible light region and having a reflectance higher than a transmittance thereof in a near-infrared region; and an air layer interposed between the photovoltaic array and the reflective film.
(2) In the glass building material, a distance between the reflective film and the first photovoltaic string may be 0.5 times or more as large as a length of the first photovoltaic string in a direction orthogonal to the first direction.
(3) The glass building material may further include a first reflective plate, which faces the second principal surface of the first photovoltaic string, and which has a shape extending in the first direction.
(4) In the glass building material, the first reflective plate may have a length in a direction orthogonal to the first direction that is equal to or longer than a length of the first photovoltaic string in the direction orthogonal to the first direction.
(5) In the glass building material, the first reflective plate may be arranged on a surface side of the reflective film that does not face the first photovoltaic string.
(6) The glass building material may further include a second glass substrate arranged between the first reflective plate and the reflective film.
(7) The glass building material may further include a fourth glass substrate arranged between the first reflective plate and the second glass substrate.
(8) The glass building material may further include a fifth glass substrate arranged between the air layer and the reflective film.
(9) The glass building material may further include a sixth glass substrate arranged between the fifth glass substrate and the reflective film.
(10) The glass building material may further include a third glass substrate interposed between the photovoltaic array and the air layer.
(11) The glass building material may further include a sealing material interposed between the first photovoltaic string and the second photovoltaic string.
(12) In the glass building material, the first photovoltaic string may have spectral sensitivity at least in a wavelength range of from 300 nm to 1,200 nm.
(13) In the glass building material, the first photovoltaic string may be a heterojunction-type photovoltaic string.
(14) In the glass building material, the reflective film may be configured to reflect at least near-infrared light of solar light entering from the first principal surface side of the first photovoltaic string to cause the near-infrared light to enter the second principal surface of the first photovoltaic string.
(15) In the glass building material, the reflective film may have textures on a surface thereof to diffusely reflect the near-infrared light to cause the near-infrared light to enter the second principal surface of the first photovoltaic string.
(16) In the glass building material, the first reflective plate may be configured to reflect at least a near-infrared component and a visible light component of solar light entering from the first principal surface side of the first photovoltaic string to cause the near-infrared component and the visible light component to enter the second principal surface of the first photovoltaic string.

### BRIEF DESCRIPTION OF DRAWINGS

FIG. 1 is a plan view for schematically illustrating a glass building material according to an embodiment of the present invention.
FIG. 2 is a sectional view for schematically illustrating the glass building material according to the embodiment.
FIG. 3 is a graph for showing wavelength-dependencies of spectral sensitivity of a first photovoltaic string and reflectances of reflective films of the glass building material according to the embodiment.
FIG. 4 is a graph for showing a relationship between a distance between the first photovoltaic string and the reflective film, and an output increase rate in the embodiment.
FIG. 5 is a sectional view for illustrating another example of the glass building material according to the embodiment.
FIG. 6 is a sectional view for illustrating still another example of the glass building material according to the embodiment.
FIG. 7 is a sectional view for illustrating yet another example of the glass building material according to the embodiment.

### Description of Embodiments

An embodiment of the present disclosure is described below with reference to the drawings.

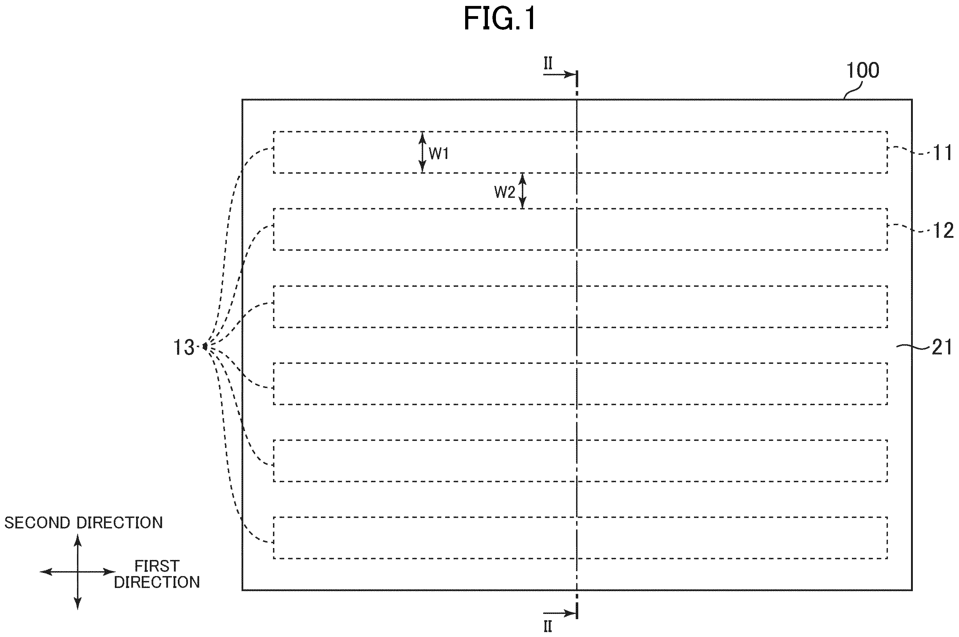

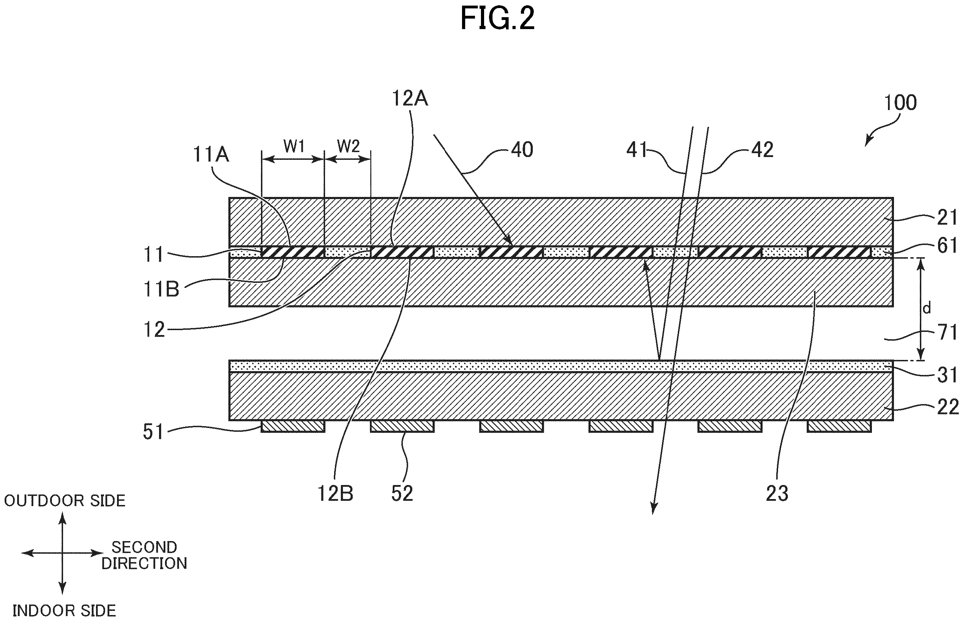

FIG. 1 is a plan view for schematically illustrating a glass building material according to this embodiment. FIG. 2 is a sectional view for illustrating a cross section taken along the line II-II of FIG. 1.

As illustrated in FIG. 1, a glass building material 100 includes a photovoltaic array including a plurality of photovoltaic strings 13 arranged so as to be spaced apart from one another, and a first glass substrate 21 formed to cover a first principal surface side of the photovoltaic array. As the plurality of photovoltaic strings 13, single-crystal silicon photovoltaic strings, polycrystalline silicon photovoltaic strings, and heterojunction-type photovoltaic strings may be used, for example, and the type of the photovoltaic strings is not particularly limited. In this embodiment, as the plurality of photovoltaic strings 13, heterojunction-type photovoltaic strings are used for description.

The "first glass substrate 21" as used herein is such a glass substrate as to be attached as, for example, a window of a building, and is formed of a material having a high transmittance so as to cause solar light to enter inside a room and on a surface of each photovoltaic string.

As illustrated in FIG. 1 and FIG. 2, the photovoltaic array includes a first photovoltaic string 11 and a second photovoltaic string 12. Each of the first photovoltaic string 11 and the second photovoltaic string 12 is formed by arranging and connecting the plurality of photovoltaic cells in line, and has a shape extending in a first direction, and the first photovoltaic string 11 has a width W1. The "width W1" means a length of the first photovoltaic string 11 in a direction orthogonal to the first direction. The second photovoltaic string 12 is arranged next to the first photovoltaic string 11 in a second direction crossing the first direction, and the first photovoltaic string 11 and the second photovoltaic string 12 are arranged via a first distance W2. A width direction of the first photovoltaic string 11 and the second photovoltaic string 12, and the direction in which the first photovoltaic string 11 and the second photovoltaic string 12 extend are in an orthogonal relationship. The first direction, which is the direction in which the first photovoltaic string 11 and the second photovoltaic string 12 extend, and the second direction, which is the direction in which the plurality of photovoltaic strings 13 are arranged, are not always required to be in the orthogonal relationship, and are only required to be in a crossing relationship.

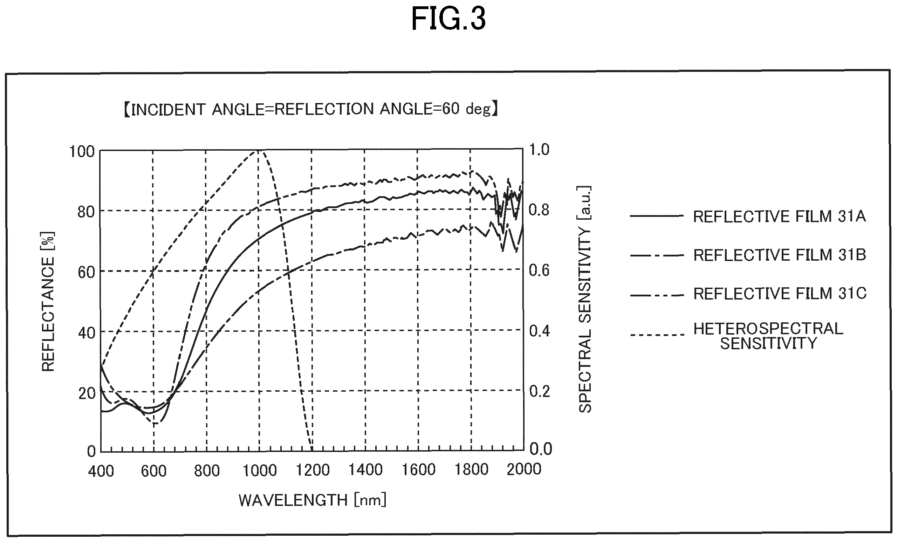

As shown in FIG. 3, the first photovoltaic string 11 has relative spectral sensitivity at about 300 nm to about 1,200 nm, and has a high value near 1,000 nm, which is in a near-infrared region. The first photovoltaic string 11 and the second photovoltaic string 12 are of a bifacial light-receiving type, with which light received by first principal surfaces 11A and 12A on an outdoor side and second principal surfaces 11B and 12B on an indoor side can contribute to power generation.

As illustrated in FIG. 2, the first principal surface 11A of the first photovoltaic string 11 and the first principal surface 12A of the second photovoltaic string 12 receive solar light beams 40 from outside the room via the first glass substrate 21.

On the second principal surface 11B side of the first photovoltaic string 11, and on the second principal surface 12B side of the second photovoltaic string 12, a reflective film 31 arranged via a second distance d from the first photovoltaic string 11 and the second photovoltaic string 12 is included. In this embodiment, the reflective film 31 is provided on a surface of a second glass substrate 22. This reflective film 31 is a low emissivity (Low-E) film, for example, and in this embodiment, a heat-shielding Low-E film, which is configured to transmit much of visible light and reflect much of near-infrared light, is used for description.

FIG. 3 is a graph for showing wavelength-dependencies of spectral sensitivity of the first photovoltaic string 11 and the second photovoltaic string 12 and reflectances of the reflective films 31 (reflective film 31A, reflective film 31B, and reflective film 31C) of the glass building material according to this embodiment. In this embodiment, heterojunction-type photovoltaic strings of the same type are used as the first photovoltaic string 11 and the second photovoltaic string 12, and hence have the same spectral sensitivity characteristic, which is shown in FIG. 3 as "heterospectral sensitivity". Further, as illustrated in FIG. 3, each of the reflective film 31A, the reflective film 31B, and the reflective film 31C has a high reflectance in the near-infrared region of from 750 nm to 2,500 nm, and has a reflectance higher than a transmittance thereof in the near-infrared region. Meanwhile, each of the reflective film 31A, the reflective film 31B, and the reflective film 31C has a low reflectance in a visible light region of from 380 nm to 750 nm, and has a transmittance higher than a reflectance thereof in the visible light region.

With the above-mentioned reflective film 31 being provided on the second principal surface 11B side of the first photovoltaic string 11, part of a near-infrared component 41 of the solar light entering from outside the room is reflected by the reflective film 31, and is received by the second principal surface 11B of the first photovoltaic string 11 and the second principal surface 12B of the second photovoltaic string 12. As described above with reference to FIG. 3, each of the first photovoltaic string 11 and the second photovoltaic string 12 has a high spectral sensitivity characteristic in the near-infrared region, with which the near-infrared component 41 reflected by the reflective film 31 can contribute to the power generation efficiently.

Meanwhile, part of a visible light component 42 of the solar light entering from outside the room passes through the reflective film 31, which has a low reflectance in the visible light region, and enters the room. Therefore, a view and a lighting property can be ensured through the glass building material 100.

Further, the near-infrared component of solar radiation is reduced with the reflective film 31, and hence a cooling load is reduced, and energy saving of the building can be achieved.

With the above-mentioned configuration, while the glass building material 100 does not lose its functions of being capable of ensuring the view and the lighting property, a power generation amount on a light-receiving surface on the indoor side can be increased, and the cooling load of the building can be reduced.

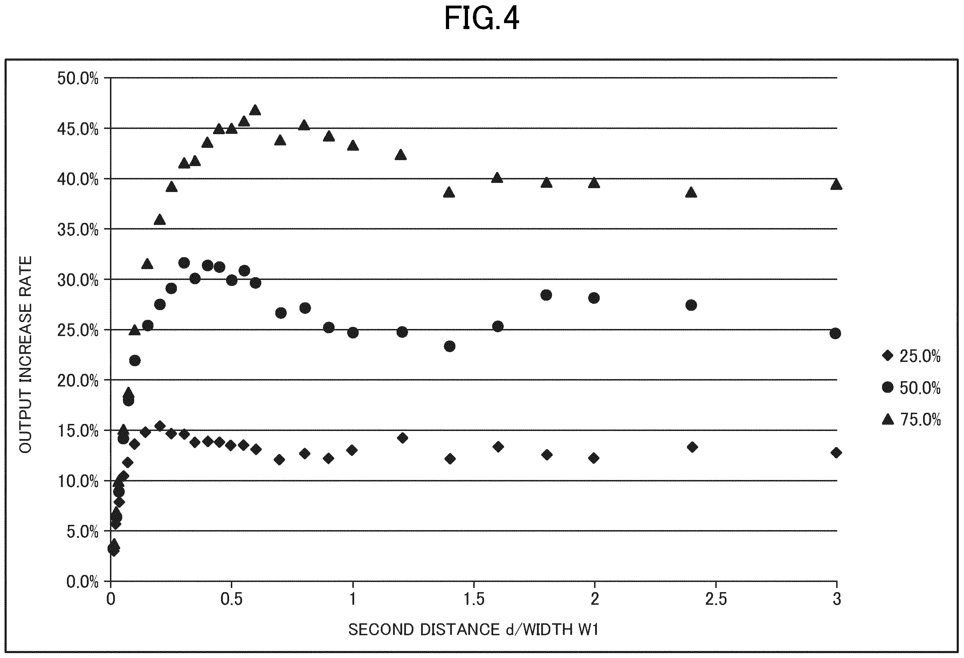

It is desired that the second distance d, which is a distance between the first photovoltaic string 11 and the reflective film 31, be 0.1 times or more as large as the width W1 of the first photovoltaic string 11, and it is more desired that the second distance d be 0.5 times or more as large as the width W1. FIG. 4 shows a relationship between the second distance d and an output increase rate of the first photovoltaic string 11 at each opening rate. The "opening rate" as used herein refers to a value obtained by dividing the first distance W2, which is a distance between the first photovoltaic string 11 and the second photovoltaic string 12, by the sum of the width W1 of the first photovoltaic string 11 and the first distance W2. A value obtained by dividing the second distance d by the width W1 of the first photovoltaic string is shown on the abscissa. When a power generation amount on only a light-receiving surface on the outdoor side is defined as 100%, a percentage of an output increase by power generation on the light-receiving surface on the indoor side with respect to a total power generation amount is derived, and is shown on the ordinate.

As apparent from FIG. 4, when the value on the abscissa is less than 0.1, the output increase rate is abruptly reduced. This indicates that, when the second distance d is significantly reduced, it becomes difficult for the second principal surface 11B of the first photovoltaic string 11 to effectively receive light reflected by the reflective film 31. Accordingly, it is desired that the second distance d, which is the distance between the first photovoltaic string 11 and the reflective film 31, be 0.1 times or more as large as the width W1 of the first photovoltaic string 11.

It is also apparent from FIG. 4 that when the value on the abscissa is 0.5 or more, a high output increase rate can be obtained. This is because, for example, when the near-infrared component 41 enters between the plurality of photovoltaic strings 13 at a near-vertical angle as illustrated in FIG. 2, through setting the second distance d to be large, the near-infrared component 41 can be caused to enter a second principal surface side of the plurality of photovoltaic strings 13. More specifically, a difference between an entering position of the near-infrared component 41 and an entering position of reflected light of the near-infrared component 41 in a layer in which the plurality of photovoltaic strings 13 are arranged becomes larger as the second distance d becomes larger. Therefore, even when, for example, the near-infrared component 41 enters at a position away from the first photovoltaic string 11 and at the near-vertical angle, through setting the second distance d to be large, the probability that the near-infrared component 41 is caused to enter the first photovoltaic string 11 can be increased.

In this embodiment, as illustrated in FIG. 2, an air layer 71 is interposed between the photovoltaic array and the reflective film 31. With the interposition of the air layer 71, the second distance d can be set to be large, to thereby achieve the configuration in which the second distance d is 0.5 times or more as large as the width W1 of the first photovoltaic string 11.

It is also appropriate to adopt a configuration in which the reflective film 31 illustrated in FIG. 2 has textures on a surface thereof, and is configured to diffusely reflect the near-infrared component 41 to cause the second principal surface 11B of the first photovoltaic string 11 and the second principal surface 12B of the second photovoltaic string 12 to receive the near-infrared component 41 irrespective of the incident angle of the solar light.

In this embodiment, as illustrated in FIG. 2, a third glass substrate 23 is arranged between the photovoltaic array and the air layer 71, and the first photovoltaic string 11 and the second photovoltaic string 12 included in the photovoltaic array are arranged between the first glass substrate 21 and the third glass substrate 23. Further, between the first glass substrate 21 and the third glass substrate 23, a sealing material 61 is interposed between the first photovoltaic string 11 and the second photovoltaic string 12 to fix the positions of the first photovoltaic string 11 and the second photovoltaic string 12. The sealing material 61 is formed of a thermosetting resin, such as an ethylene vinyl acetate copolymer (EVA) resin, and is configured to protect the plurality of photovoltaic strings 13 and fix the positions of the plurality of photovoltaic strings 13 in the glass building material 100.

In this embodiment, as illustrated in FIG. 2, on a surface side of the reflective film 31 that does not face the first photovoltaic string 11, that is, on the indoor side of the reflective film 31, a first reflective plate 51 facing the second principal surface 11B of the first photovoltaic string 11 and a second reflective plate 52 facing the second principal surface 12B of the second photovoltaic string 12 are arranged.

The first reflector 51 and the second reflective plate 52 are each, for example, a metal plate or a white reflective plate, and can cause the second principal surface 11B of the first photovoltaic string 11 and the second principal surface 12B of the second photovoltaic string 12 to receive the near-infrared component 41 and the visible light component 42 each entering from outside the room.

In this embodiment, the first reflective plate 51 and the second reflective plate 52 are bonded on the indoor side of the second glass substrate 22 to provide a configuration in which the second glass substrate 22 is interposed between each of the first reflective plate 51 and the second reflective plate 52, and the reflective film 31.

The first reflective plate 51 and the second reflective plate 52 each have a shape extending in the first direction as with the first photovoltaic string 11 and the second photovoltaic string 12. Therefore, part of the visible light component 42 of the solar light entering between the first photovoltaic string 11 and the second photovoltaic string 12 passes between the first reflective plate 51 and the second reflective plate 52 to enter the room. Accordingly, a person in the room can see a view outside the room through the glass building material 100.

When a configuration in which a width W3 of the first reflective plate 51 is set to be larger than the width W1 of the first photovoltaic string is adopted, the near-infrared component 41 and the visible light component 42 each entering the first reflective plate 51 can be received on the second principal surface 11B of the first photovoltaic string 11 more efficiently. In addition, a light shielding property of the glass building material 100 can be increased. Further, there is a merit in terms of design seen from the indoor side that the second principal surface 11B side of the first photovoltaic string 11 can be hidden by the first reflective plate 51. The "width W3" of the first reflective plate 51 means a length of the first reflective plate 51 in the direction orthogonal to the first direction.

Further, with the configuration in which the first reflective plate 51 and the second reflective plate 52 are arranged on the surface side of the second glass substrate 22 that does not face the first photovoltaic string 11, that is, on the indoor side, relative positional relationships in which the positions of the first reflective plate 51 and the second reflective plate 52 are accurately matched with the positions of the first photovoltaic string 11 and the second photovoltaic string 12, respectively, can be achieved. That is, the first reflective plate 51 and the second reflective plate 52 can be arranged after the positions of the first glass substrate 21 and the second glass substrate 22 are fixed with the sealing material 61 while the positions of the first photovoltaic string 11 and the second photovoltaic string 12 are checked. Therefore, the first reflective plate 51 and the second reflective plate 52 can be accurately arranged to desired positions.

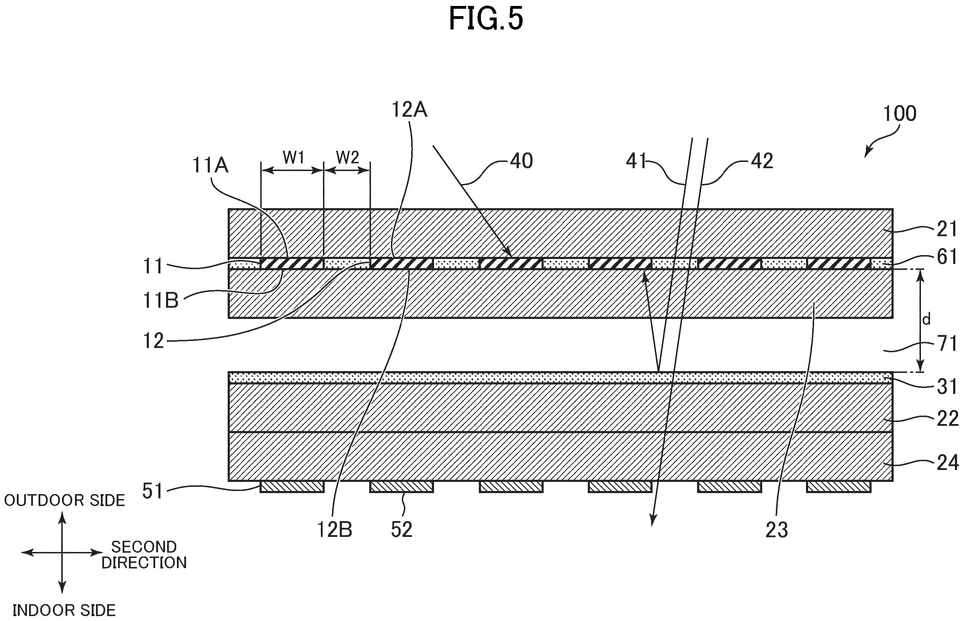

As illustrated in FIG. 5, there may be adopted a configuration further including a fourth glass substrate 24 interposed between the first reflective plate 51 and the second glass substrate 22, and between the second reflective plate 52 and the second glass substrate 22.

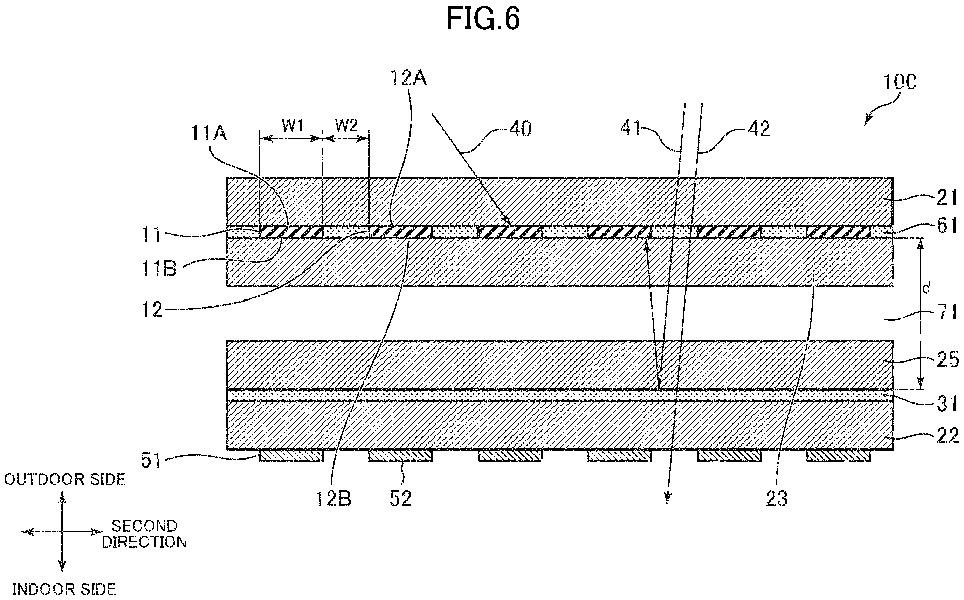

Further, as illustrated in FIG. 6, there may be adopted a configuration further including a fifth glass substrate 25 interposed between the air layer 71 and the reflective film 31. With this configuration, a thickness of the fifth glass substrate 25 may be controlled to control the second distance d.

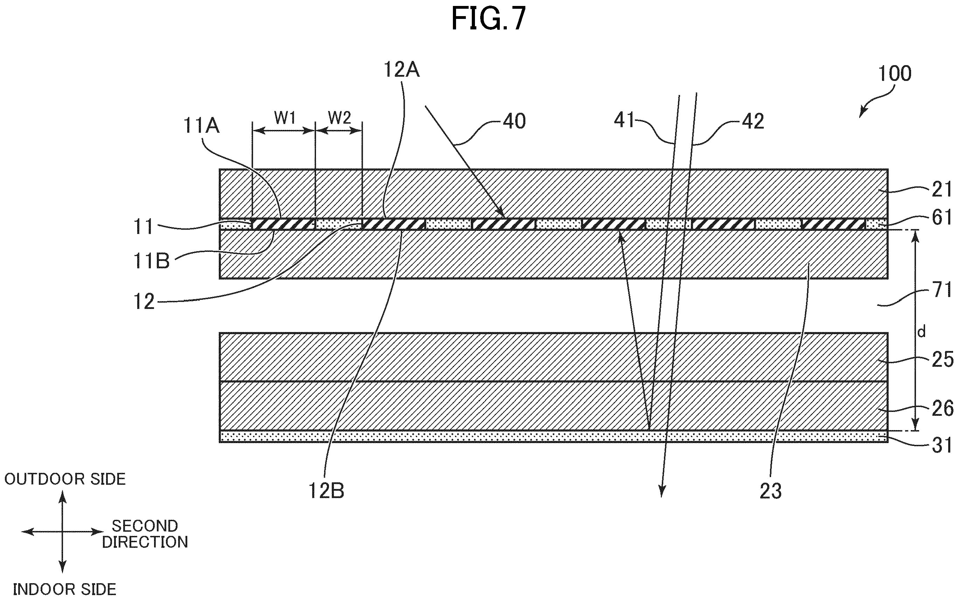

Further, as illustrated in FIG. 7, there may be adopted a configuration further including a sixth glass substrate 26 between the fifth glass substrate 25 and the reflective film 31. With this configuration, thicknesses of the fifth glass substrate 25 and the sixth glass substrate 26 may be controlled to control the second distance d. In the example illustrated in FIG. 7, the configuration does not include the second glass substrate 22, and the first reflective plate 51 and the second reflective plate 52 on the surface side of the reflective film 31 that does not face the first photovoltaic string 11, that is, on the indoor side. However, as with the configuration described above with reference to FIG. 2, FIG. 5, and FIG. 6, there may be adopted a configuration including the second glass substrate 22, and the first reflective plate 51 and the second reflective plate 52 on the indoor side of the reflective film 31.

In this embodiment, while the Low-E film has been given as an example of the reflective film 31, any other film having a transmittance higher than a reflectance thereof in the visible light region, and having a reflectance higher than a transmittance thereof in the near-infrared region may be used. For example, the reflective film 31 may be a transparent conductive oxide (TCO) film contrived to increase a reflectance in the near-infrared region through adjustment of a tin oxide component. In addition, the reflective film 31 may be formed of a plurality of reflective films having different reflection peaks at different wavelengths.

## Claims

1. A glass building material, comprising:
a photovoltaic array including: a first photovoltaic string of a bifacial light-receiving type, which has a shape extending in a first direction; and a second photovoltaic string of a bifacial light-receiving type, which is arranged next to the first photovoltaic string in a second direction crossing the first direction, and has a shape extending in the first direction;
a first glass substrate covering a first principal surface side of the photovoltaic array;
a reflective film arranged at least partially on a second principal surface side of the photovoltaic array, the reflective film having a transmittance higher than a reflectance thereof in a visible light region and having a reflectance higher than a transmittance thereof in a near-infrared region; and
an air layer interposed between the photovoltaic array and the reflective film.

2. The glass building material according to claim 1, wherein a distance between the reflective film and the first photovoltaic string is 0.5 times or more as large as a length of the first photovoltaic string in a direction orthogonal to the first direction.

3. The glass building material according to claim 1 or 2, further comprising a first reflective plate, which faces the second principal surface of the first photovoltaic string, and has a shape extending in the first direction.

4. The glass building material according to claim 3, wherein the first reflective plate has a length in a direction orthogonal to the first direction that is equal to or longer than a length of the first photovoltaic string in the direction orthogonal to the first direction.

5. The glass building material according to claim 3, wherein the first reflective plate is arranged on a surface side of the reflective film that does not face the first photovoltaic string.

6. The glass building material according to claim 5, further comprising a second glass substrate arranged between the first reflective plate and the reflective film.

7. The glass building material according to claim 6, further comprising a fourth glass substrate arranged between the first reflective plate and the second glass substrate.

8. The glass building material according to claim 6, further comprising a fifth glass substrate arranged between the air layer and the reflective film.

9. The glass building material according to claim 8, further comprising a sixth glass substrate arranged between the fifth glass substrate and the reflective film.

10. The glass building material according to any one of claims 1 to 9, further comprising a third glass substrate interposed between the photovoltaic array and the air layer.

11. The glass building material according to any one of claims 1 to 10, further comprising a sealing material interposed between the first photovoltaic string and the second photovoltaic string.

12. The glass building material according to any one of claims 1 to 11, wherein the first photovoltaic string has spectral sensitivity at least in a wavelength range of from 300 nm to 1,200 nm.

13. The glass building material according to claim 12, wherein the first photovoltaic string is a heterojunction-type photovoltaic string.

14. The glass building material according to any one of claims 1 to 13, wherein the reflective film is configured to reflect at least near-infrared light of solar light entering from the first principal surface side of the first photovoltaic string to cause the near-infrared light to enter the second principal surface of the first photovoltaic string.

15. The glass building material according to claim 14, wherein the reflective film has textures on a surface thereof to diffusely reflect the near-infrared light to cause the near-infrared light to enter the second principal surface of the first photovoltaic string.

16. The glass building material according to any one of claims 3 to 7, wherein the first reflective plate is configured to reflect at least a near-infrared component and a visible light component of solar light entering from the first principal surface side of the first photovoltaic string to cause the near-infrared component and the visible light component to enter the second principal surface of the first photovoltaic string.
